# EUROPEAN PATENT SPECIFICATION

(11) **EP 4 475 040 B1**
(45) Date of publication and mention of the grant of the patent: **09.12.2026**
(21) Application number: 24180724.7
(22) Date of filing: 07.06.2024
(51) Int. Cl.: G06N 10/40

(54) **SYSTEM AND METHOD OF MODULATING TRANSITION FREQUENCY OF SUPERCONDUCTING QUANTUM BIT**
SYSTEM UND VERFAHREN ZUR MODULATION DER ÜBERGANGSFREQUENZ EINES SUPRALEITENDEN QUANTENBITS
SYSTÈME ET PROCÉDÉ DE MODULATION DE FRÉQUENCE DE TRANSITION DE BIT QUANTIQUE SUPRACONDUCTEUR

(30) Priority: 09.06.2023 CN 202310680483
(43) Date of publication of application: 11.12.2024
(73) Proprietor: University of Science and Technology of China, Anhui 230026 (CN); Hefei National Laboratory, Hefei 230088 (CN)
(72) Inventor: JIANG, Lei, Hefei, 230088 (CN); XU, Yu, Hefei, 230088 (CN); LI, Shaowei, Hefei, 230088 (CN); SUN, Chenyin, Hefei, 230088 (CN); SUN, Tianzuo, Hefei, 230088 (CN); JIANG, Tao, Hefei, 230088 (CN); LI, Jinjin, Hefei, 230088 (CN); PENG, Chengzhi, Hefei, 230088 (CN); ZHU, Xiaobo, Hefei, 230088 (CN); PAN, Jianwei, Hefei, 230088 (CN)
(74) Representative: Isarpatent

(56) References cited:
- ALLMAN M. S. ET AL: "rf-SQUID-Mediated Coherent Tunable Coupling between a Superconducting Phase Qubit and a Lumped-Element Resonator", PHYSICAL REVIEW LETTERS, vol. 104, no. 17, 1 April 2010 (2010-04-01), US, XP093216946, ISSN: 0031-9007, DOI: 10.1103/PhysRevLett.104.177004
- ALLMAN M. S. ET AL: "Tunable Resonant and Nonresonant Interactions between a Phase Qubitand LC Resonator", PHYSICAL REVIEW LETTERS, vol. 112, no. 12, 1 March 2014 (2014-03-01), US, XP093216945, ISSN: 0031-9007, DOI: 10.1103/PhysRevLett.112.123601
- POLETTO S ET AL: "A tunable rf SQUID manipulated as flux and phase qubit", ARXIV.ORG, CORNELL UNIVERSITY LIBRARY, 201 OLIN LIBRARY CORNELL UNIVERSITY ITHACA, NY 14853, 23 October 2009 (2009-10-23), XP080373626, DOI: 10.1088/0031-8949/2009/T137/014011
- BERKLEY A J ET AL: "A scalable readout system for a superconducting adiabatic quantum optimization system", ARXIV.ORG, CORNELL UNIVERSITY LIBRARY, 201 OLIN LIBRARY CORNELL UNIVERSITY ITHACA, NY 14853, 6 May 2009 (2009-05-06), XP080323018, DOI: 10.1088/0953-2048/23/10/105014
- LEI JIANG ET AL: "In situ Qubit Frequency Tuning Circuit for Scalable Superconducting Quantum Computing: Scheme and Experiment", ARXIV.ORG, CORNELL UNIVERSITY LIBRARY, 201 OLIN LIBRARY CORNELL UNIVERSITY ITHACA, NY 14853, 31 July 2024 (2024-07-31), XP091836031

## Description

### TECHNICAL FIELD

The present disclosure relates to a field of superconducting quantum computing, and in particular to a system and a method of modulating a transition frequency of a superconducting quantum bit.

### BACKGROUND

Quantum computing is expected to solve problems that cannot be solved by current classical computing in many fields, such as multi-body physics simulation, encryption algorithm design, chemical reaction simulation, and prediction of biological microscopic behavior. Superconducting quantum computers based on superconductor materials are important platforms for achieving quantum computing. An important technical means for implementing quantum logic gates, quantum state measurement, quantum algorithms and general quantum computing in superconducting quantum computers is to regulate a transition frequency of a superconducting quantum bit. The related art involves placing an on-chip microwave transmission line near the superconducting quantum bit. Such a transmission line is integrated with the quantum bit on the same chip. An electrical signal (including current signal and voltage signal) in the transmission line may be converted into a magnetic flux signal through a mutual inductance between the transmission line and the quantum bit. The magnetic flux signal may be input into the quantum bit to change the transition frequency of the quantum bit. However, the related art has problems such as high power consumption and poor scalability.

Allman M. S. et al: "rf-SQUID-Mediated Coherent Tunable Coupling between a Superconducting Phase Qubit and a Lumped-Element Resonator", XP093216946 discloses rf-SQUID-Mediated Coherent Tunable Coupling between a Superconducting Phase Qubit and a Lumped-Element Resonator.

Allman M. S. et al: "Tunable Resonator and Nonresonant Interactions between a Phase Qubitand LC Resonator", XP093216945 discloses Tunable Resonator and Nonresonant Interactions between a Phase Qubitand LC Resonator.

Poletto S. et al: "A tunable rf SQUID manipulated as flux and phase qubit", XP080373626 discloses a tunable rf SQUID manipulated as flux and phase qubit.

Berkley A. J. et al: "A scalable readout system for a superconducting adiabatic quantum optimization system", XP080323018 discloses a scalable readout system for a superconducting adiabatic quantum optimization system.

### SUMMARY

The invention is set out in independent claims 1 and 7.

Preferred aspects of the invention are set out in the dependent claims.

### BRIEF DESCRIPTION OF THE DRAWINGS

The above contents and other objectives, features and advantages of the present disclosure will become more apparent through the following description of the embodiments of the present disclosure with reference to the accompanying drawings. In the accompanying drawings:
FIG. 1 shows a schematic structural diagram of a system of modulating a transition frequency of a superconducting quantum bit according to embodiments of the present disclosure;
FIG. 2 shows a flowchart of a method of modulating a transition frequency of a superconducting quantum bit according to embodiments of the present disclosure; and
FIG. 3 shows a schematic diagram of a hysteresis loop relationship between a total magnetic flux *Φ* and an external magnetic flux *Φₑ* of a radio frequency superconducting quantum interference device according to embodiments of the present disclosure.

### DETAILED DESCRIPTION OF EMBODIMENTS

In order to make objectives, technical solutions and advantages of the present disclosure more clearly understood, the present disclosure will be further described in detail below in conjunction with specific embodiments and with reference to the accompanying drawings.

It should be noted that the figures provided in the embodiments of the present disclosure are just used to illustrate the basic concept of the present disclosure in a schematic manner. The figures only show components related to the present disclosure and are not drawn according to the number, shape and size of components in actual implementation. The type, quantity and proportion of each component may be changed arbitrarily in actual implementation, and a layout of components may be more complicated.

In a superconducting quantum computer in the related art, an on-chip microwave transmission line is placed near a superconducting quantum bit, and the transmission line is integrated with the quantum bit on the same chip. An electrical signal in the transmission line may be converted into a magnetic flux signal through a mutual inductance between the transmission line and the quantum bit, and the magnetic flux signal may be input into the quantum bit to change a transition frequency of the quantum bit.

However, the solutions in the related art have the following disadvantages. First, the electrical signal needs to be continuously input from a signal source at a room temperature to a superconducting quantum processor in a low-temperature environment of a refrigerator. The continuously input electrical signal may generate heat when passing through various attenuators on a low-temperature coaxial cable in the refrigerator. Long-term heating may make it difficult to maintain the low-temperature environment in the refrigerator, and a thermal radiation generated by the heating may also affect a performance of the quantum processor. Secondly, with an increase in the number of quantum bits, a demand for the number of coaxial transmission lines in the refrigerator may also increase exponentially, which requires a larger physical space inside the refrigerator and puts higher requirements on cooling power of the refrigerator, and thus limits a scalability of the superconducting quantum processor.

Therefore, it is important and urgent to achieve a low-power scalable solution for modulating a transition frequency of a quantum bit on a future superconducting processor with thousands of quantum bits.

In view of the above, the present disclosure provides a system and a method of modulating a transition frequency of a superconducting quantum bit to achieve the solution of modulating the transition frequency of the superconducting quantum bit, so as to solve the problems of high energy consumption and non-scalability in the related art.

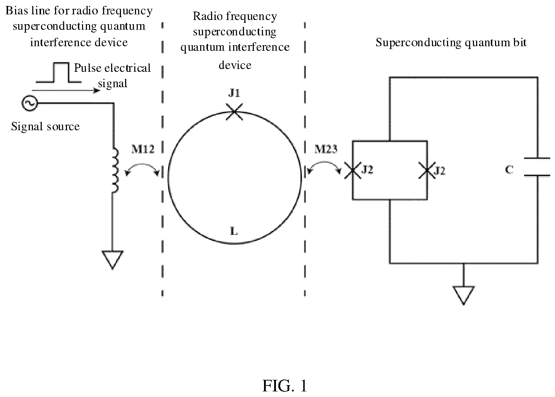

FIG. 1 shows a schematic structural diagram of a system of modulating a transition frequency of a superconducting quantum bit according to embodiments of the present disclosure.

As shown in FIG. 1, the system of modulating the transition frequency of the superconducting quantum bit includes: at least one bias line for a radio frequency superconducting quantum interference device, which is used to transmit an electrical signal for adjusting a state of the radio frequency superconducting quantum interference device; at least one radio frequency superconducting quantum interference device located on a chip and placed near the superconducting quantum bit, where a hysteresis parameter of the radio frequency superconducting quantum interference device is greater than 1; at least one superconducting quantum bit, where the transition frequency of the superconducting quantum bit is modulated by applying an external magnetic flux; where the system used to modulate the transition frequency of the superconducting quantum bit operates in an extremely low temperature environment of an order of 10 mK in a dilution refrigerator.

The hysteresis parameter of the above-mentioned radio frequency superconducting quantum interference device is expressed by Equation (1). ${β}_{e} = 2 π \frac{{I}_{c} L}{{Φ}_{0}}$ (1) where *I_{c}* represents a critical Josephson current in the radio frequency superconducting quantum interference device, *L* represents a self-inductance of the radio frequency superconducting quantum interference device, and *Φ*₀ represents a magnetic flux quantum. *Φ*₀ is expressed by Equation (2). ${Φ}_{0} = 2.07 \times {10}^{- 15} V ⋅ s$ (2)

It should be clear to those skilled in the art that a transmon qubit is taken as an example in FIG. 1, but the above-mentioned system provided by the present disclosure is not limited to the transmon qubit.

The above-mentioned radio frequency superconducting quantum interference device (RF-SQUID) is based on a superconducting Josephson effect and a magnetic flux quantization, and is generally used to measure a weak magnetic signal.

The radio frequency superconducting quantum interference device is placed in a range of 0.1 microns to 20 microns of the superconducting quantum bit.

As shown in FIG. 1, M12 represents a mutual inductance between the bias line for the radio frequency superconducting quantum interference device and the radio frequency superconducting quantum interference device, M23 represents a mutual inductance between the radio frequency superconducting quantum interference device and the superconducting quantum bit (that is, superconducting quantum bit circuit), C represents a capacitance, J1 represents a Josephson junction of the radio frequency superconducting quantum interference device, J2 represents a Josephson junction in the superconducting quantum bit, and L represents a self-inductance coil of the radio frequency superconducting quantum interference device.

The system provided by the present disclosure is implemented to modulate a transition frequency of a superconducting quantum bit based on a radio frequency superconducting quantum interference device. The electrical signal used in the system may modulate the transition frequency of the superconducting quantum bit for a long time using a limited number of pulse signal inputs with an extremely low energy consumption. Moreover, the radio frequency superconducting quantum interference device is integrated on the chip for easy expansion, which may help provide a scalable transition frequency modulation solution for a future superconducting quantum computer with thousands of superconducting quantum bits.

According to embodiments of the present disclosure, the bias line for the radio frequency superconducting quantum interference device is coupled with the radio frequency superconducting quantum interference device through a mutual inductance. The bias line for the radio frequency superconducting quantum interference device is located on the chip, and is connected to a signal source in a room temperature environment through a coaxial cable in a dilution refrigerator. The bias line for the radio frequency superconducting quantum interference device may convert an electrical signal into a magnetic flux signal through the mutual inductance between the bias line and the radio frequency superconducting quantum interference device, and input the magnetic flux signal into the radio frequency superconducting quantum interference device. A bandwidth of the bias line for the radio frequency superconducting quantum interference device may cover at least a frequency range from a frequency of DC signal to 5 GHz. The state of the radio frequency superconducting quantum interference device may be modulated by an electrical signal with a specific direction and a specific amplitude inputted to the bias line for the radio frequency superconducting quantum interference device.

According to embodiments of the present disclosure, the radio frequency superconducting quantum interference device is a closed loop including a superconducting ring made of a superconducting material and at least one Josephson junction connected with the superconducting ring end to end.

According to embodiments of the present disclosure, a mutual inductance coupling is formed between the superconducting quantum bit and the radio frequency superconducting quantum interference device.

According to embodiments of the present disclosure, the bias line for the radio frequency superconducting quantum interference device may convert an input electrical signal into a magnetic flux signal through a mutual inductance and input the magnetic flux signal into the radio frequency superconducting quantum interference device. The input electrical signal is a current signal or a voltage signal.

According to embodiments of the present disclosure, a superconducting ring current in the radio frequency superconducting quantum interference device may be converted into a magnetic flux signal through a mutual inductance and input into the superconducting quantum bit, so as to modulate the transition frequency of the superconducting quantum bit.

According to embodiments of the present disclosure, a relationship between a total magnetic flux of the radio frequency superconducting quantum interference device and the external magnetic flux exhibits a behavior of a hysteresis curve, and an external magnetic flux signal in form of pulse is applied to modulate the state of the radio frequency superconducting quantum interference device. The state of the radio frequency superconducting quantum interference device includes a direction and a magnitude of the superconducting ring current in the radio frequency superconducting quantum interference device.

According to embodiments of the present disclosure, the state of the radio frequency superconducting quantum interference device may be maintained in a changed state for a long time after being changed by a pulse signal input; and the direction and the magnitude of the superconducting ring current in the radio frequency superconducting quantum interference device may be kept constant for a long time.

The state of the radio frequency superconducting quantum interference device may be maintained for a very long time after being changed by a pulse signal input. For example, for a radio frequency superconducting quantum interference device with a critical Josephson current of 100 microamperes at a stable ambient temperature of 20 mK, the state of the radio frequency superconducting quantum interference device may be maintained for 10¹⁴ seconds, i.e., three million years.

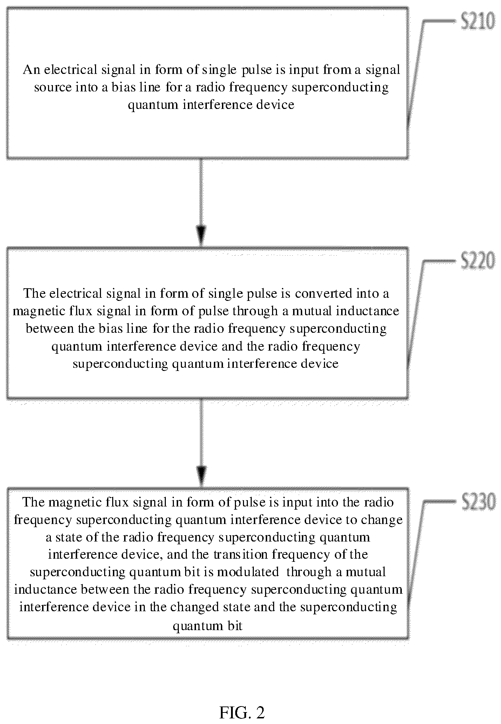

FIG. 2 shows a flowchart of a method of modulating a transition frequency of a superconducting quantum bit according to embodiments of the present disclosure.

As shown in FIG. 2, the method of modulating the transition frequency of the superconducting quantum bit may be applied to a system of modulating a transition frequency of a superconducting quantum bit, and may include operation S210 to operation S230.

In operation S210, an electrical signal in form of single pulse is input from a signal source into a bias line for a radio frequency superconducting quantum interference device, where the single pulse electrical signal may be a current signal or a voltage signal.

In operation S220, the electrical signal in form of single pulse is converted into a magnetic flux signal in form of pulse through a mutual inductance between the bias line for the radio frequency superconducting quantum interference device and the radio frequency superconducting quantum interference device.

In operation S230, the magnetic flux signal in form of pulse is input into the radio frequency superconducting quantum interference device to change a state of the radio frequency superconducting quantum interference device so that the radio frequency superconducting quantum interference device in a changed state modulates the transition frequency of the superconducting quantum bit through a mutual inductance between the radio frequency superconducting quantum interference device and the superconducting quantum bit, where a hysteresis parameter of the radio frequency superconducting quantum interference device is greater than 1.

According to embodiments of the present disclosure, inputting the magnetic flux signal in form of pulse into the radio frequency superconducting quantum interference device to change a state of the radio frequency superconducting quantum interference device so that the radio frequency superconducting quantum interference device in a changed state modulates the transition frequency of the superconducting quantum bit through a mutual inductance between the radio frequency superconducting quantum interference device and the superconducting quantum bit may include: converting, by using the bias line, the electrical signal in form of single pulse with a specific direction and a specific amplitude into an external magnetic flux signal in form of single pulse through a mutual inductance between the bias line and the radio frequency superconducting quantum interference device according to a hysteresis loop relationship between the external magnetic flux and the total magnetic flux of the radio frequency superconducting quantum interference device, and inputting the external magnetic flux signal in form of single pulse into the radio frequency superconducting quantum interference device to change the state of the radio frequency superconducting quantum interference device, where the state of the radio frequency superconducting quantum interference device includes a direction and a magnitude of a superconducting ring current in the radio frequency superconducting quantum interference device; and modulating, by using the superconducting ring current, the transition frequency of the superconducting quantum bit through a mutual inductance between the radio frequency superconducting quantum interference device and the superconducting quantum bit; where the direction of the superconducting ring current in the radio frequency superconducting quantum interference device is related to a direction of the external magnetic flux signal in form of single pulse inputted the radio frequency superconducting quantum interference device; and the magnitude of the superconducting ring current in the radio frequency superconducting quantum interference device is related to an amplitude of the single pulse external magnetic flux signal in form of single pulse inputted the radio frequency superconducting quantum interference device.

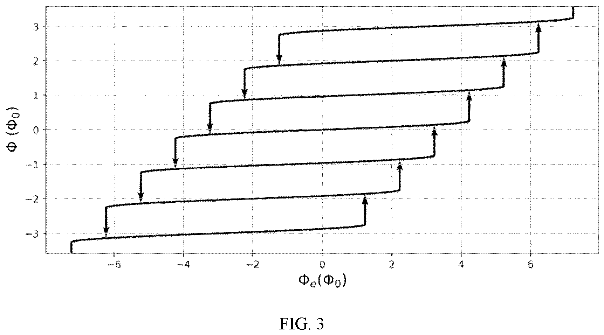

In order to better illustrate the advantages of the above-mentioned method, the above-mentioned method will be further described in detail in the present disclosure with reference to FIG. 3 and specific embodiments.

FIG. 3 shows a schematic diagram of a hysteresis loop relationship between a total magnetic flux *Φ* and an external magnetic flux *Φₑ* of a radio frequency superconducting quantum interference device according to embodiments of the present disclosure.

Specifically, in such embodiments, an electrical signal in form of single pulse (which may be a current signal or a voltage signal) is input from a signal source into a bias line for an RF-SQUID, and is converted into a magnetic flux signal in form of pulse through a mutual inductance M12 between the bias line for the RF-SQUID and the RF-SQUID and input into the RF-SQUID. Since the hysteresis parameter of the RF-SQUID is greater than 1, a relationship between a total magnetic flux and an external magnetic flux of the RF-SQUID exhibits a hysteresis loop relationship, as shown in FIG. 3. An amplitude of the pulse electrical signal applied by the signal source is adjusted. When an amplitude of the converted magnetic flux signal reaches a value at a critical point (a magnitude of the external magnetic flux corresponding to a starting position of each arrow in FIG. 3) of the external magnetic flux in the hysteresis loop relationship between the total magnetic flux and the external magnetic flux of the RF-SQUID, the relationship between the total magnetic flux and the external magnetic flux of the RF-SQUID may jump from a relationship indicated by a previous curve to a relationship indicated by a next curve corresponding to the critical point. A specific jumping direction depends on whether a changing direction of the external magnetic flux is positive or negative, as shown by upward and downward arrows in FIG. 3. Here, the state of the RF-SQUID is described by a parameter of total magnetic flux, and a state change behavior of the RF-SQUID after a jump may follow the relationship described by the curve after the jump. At this time, if the external magnetic flux gradually decreases to 0, the total magnetic flux of the RF-SQUID may also gradually decrease along a curve path after the jump. Finally, the state of the RF-SQUID stays at the intercept position of the y-axis of the curve and may remain stable in the state corresponding to that position for a long time. In the state corresponding to the intercept position, the total magnetic flux of the RF-SQUID is non-zero. In other words, a superconducting ring current with a specific direction and a specific magnitude exists in the RF-SQUID. Such superconducting ring current may be converted into a magnetic flux signal through a mutual inductance M23 between the RF-SQUID and the superconducting quantum bit, and input into a transmon qubit (the transmon qubit is taken as an example here, but the above-mentioned method provided by the present disclosure is not limited to the transmon qubit) to modulate a transition frequency of the transmon qubit. Since the RF-SQUID may be maintained at the state corresponding to the intercept position of the curve for a very long time, the superconducting current in the RF-SQUID is very stable, which ensures that the modulation of the transition frequency of the superconducting quantum bit is also very stable. Similarly, the state of the RF-SQUID may also be reversely modulated according to the hysteresis loop relationship between the total magnetic flux and the external magnetic flux of the RF-SQUID, so that the RF-SQUID is modulated from a superconducting ring current state of non-zero to a state of zero or even a superconducting ring current state with a reverse current direction. In this way, the transition frequency of the superconducting quantum bit may be modulated by inputting forward and reverse magnetic fluxes from the perspective of the quantum bit.

In summary, with the method of modulating the transition frequency of the superconducting quantum bit based on the RF-SQUID according to the present disclosure, the transition frequency of the superconducting quantum bit may be modulated to be stable for a long time by inputting just an electrical signal in form of pulse. Compared with the current solution of on-chip microwave transmission line which requires inputting a continuous electrical signal, inputting an electrical signal in form of pulse may significantly reduce an energy consumption of an entire modulation process, which makes it possible to simultaneously modulate the transition frequency of all superconducting quantum bits in a superconducting quantum processor with thousands of quantum bits in the future.

The above specific embodiments further describe the objectives, technical solutions and beneficial effects of the present disclosure in detail. It should be understood that the above are just specific embodiments of the present disclosure and are not intended to limit the present disclosure.

## Claims

1. A system of modulating a transition frequency of a superconducting quantum bit, comprising:
at least one bias line for a radio frequency superconducting quantum interference device, configured to transmit an electrical signal for adjusting a state of the radio frequency superconducting quantum interference device;
at least one radio frequency superconducting quantum interference device located on a chip and placed in a range of 0.1 microns to 20 microns of the superconducting quantum bit, wherein a hysteresis parameter of the radio frequency superconducting quantum interference device is greater than 1; and
at least one superconducting quantum bit, wherein the transition frequency of the superconducting quantum bit is modulated by applying an external magnetic flux (*Φₑ*);
wherein the system of modulating the transition frequency of the superconducting quantum bit is operable in an extremely low temperature environment of an order of 10 mK of a dilution refrigerator,
wherein a relationship between a total magnetic flux (*Φ*) of the radio frequency superconducting quantum interference device and the external magnetic flux (*Φₑ*) exhibits a behavior of a hysteresis curve, an external magnetic flux signal in form of pulse is applied to modulate the state of the radio frequency superconducting quantum interference device, and the state of the radio frequency superconducting quantum interference device comprises a direction and a magnitude of a superconducting ring current in the radio frequency superconducting quantum interference device,
wherein the direction and the magnitude of the superconducting ring current in the radio frequency superconducting quantum interference device are maintained in an intercept position on a total magnetic flux axis of a hysteresis loop of the total magnetic flux (*Φ*) and the external magnetic flux (*Φₑ*) of the radio frequency superconducting quantum interference device,
wherein the transition frequency of the superconducting quantum bit is modulated by the superconducting ring current in the radio frequency superconducting quantum interference device.

2. The system according to claim 1, wherein the bias line for the radio frequency superconducting quantum interference device is coupled with the radio frequency superconducting quantum interference device through a mutual inductance (M12);
wherein the bias line for the radio frequency superconducting quantum interference device is located on the chip and is connected to a signal source in a room temperature environment through a coaxial cable in the dilution refrigerator;
wherein the bias line for the radio frequency superconducting quantum interference device is configured to convert the electrical signal into a magnetic flux signal through the mutual inductance (M12) between the bias line and the radio frequency superconducting quantum interference device and input the magnetic flux signal into the radio frequency superconducting quantum interference device;
wherein a bandwidth of the bias line of the radio frequency superconducting quantum interference device covers at least a frequency range from a frequency of DC signal to 5 GHz; and
wherein the state of the radio frequency superconducting quantum interference device is modulated by an electrical signal with a specific direction and a specific amplitude inputted to the bias line for the radio frequency superconducting quantum interference device.

3. The system according to claim 1 or 2, wherein the radio frequency superconducting quantum interference device is a closed loop comprising a superconducting ring made of a superconducting material and at least one Josephson junction (J1) connected with the superconducting ring end to end.

4. The system according to any one of the preceding claims, wherein a mutual inductance coupling (M23) is formed between the superconducting quantum bit and the radio frequency superconducting quantum interference device.

5. The system according to claim 2, wherein the bias line for the radio frequency superconducting quantum interference device is configured to convert an input electrical signal into a magnetic flux signal through the mutual inductance (M12) and input the magnetic flux signal into the radio frequency superconducting quantum interference device, and the input electrical signal is a current signal or a voltage signal.

6. The system according to claim 4, wherein the superconducting ring current in the radio frequency superconducting quantum interference device is converted into a magnetic flux signal through the mutual inductance (M23) and input into the superconducting quantum bit to modulate the transition frequency of the superconducting quantum bit.

7. A method of modulating a transition frequency of a superconducting quantum bit, applied to the system according to any one of claims 1 to 6, wherein the method comprises:
inputting (S210) the electrical signal in form of single pulse from a signal source into the bias line for the radio frequency superconducting quantum interference device, wherein the electrical signal in form of single pulse is a current signal or a voltage signal;
converting (S220) the electrical signal in form of single pulse into a magnetic flux signal in form of pulse through a mutual inductance (M12) between the bias line for the radio frequency superconducting quantum interference device and the radio frequency superconducting quantum interference device;
inputting (S230) the magnetic flux signal in form of pulse into the radio frequency superconducting quantum interference device to change a state of the radio frequency superconducting quantum interference device, so that the radio frequency superconducting quantum interference device in a changed state modulates the transition frequency of the superconducting quantum bit through a mutual inductance (M23) between the radio frequency superconducting quantum interference device and the superconducting quantum bit, wherein a hysteresis parameter of the radio frequency superconducting quantum interference device is greater than 1.

8. The method according to claim 7, wherein the inputting (S230) the magnetic flux signal in form of pulse into the radio frequency superconducting quantum interference device to change a state of the radio frequency superconducting quantum interference device so that the radio frequency superconducting quantum interference device in a changed state modulates the transition frequency of the superconducting quantum bit through a mutual inductance (M23) between the radio frequency superconducting quantum interference device and the superconducting quantum bit comprises:
converting, by using the bias line, the electrical signal in form of single pulse with a specific direction and a specific amplitude into an external magnetic flux signal in form of single pulse through a mutual inductance (M12) between the bias line and the radio frequency superconducting quantum interference device according to a hysteresis loop relationship between the external magnetic flux (*Φₑ*) and the total magnetic flux (*Φ*) of the radio frequency superconducting quantum interference device, and inputting the external magnetic flux signal in form of single pulse into the radio frequency superconducting quantum interference device to change the state of the radio frequency superconducting quantum interference device, wherein the state of the radio frequency superconducting quantum interference device comprises a direction and a magnitude of a superconducting ring current in the radio frequency superconducting quantum interference device; and
modulating, by using the superconducting ring current, the transition frequency of the superconducting quantum bit through a mutual inductance (M23) between the radio frequency superconducting quantum interference device and the superconducting quantum bit;
wherein the direction of the superconducting ring current in the radio frequency superconducting quantum interference device is related to a direction of the external magnetic flux signal in form of single pulse inputted the radio frequency superconducting quantum interference device; and
wherein the magnitude of the superconducting ring current in the radio frequency superconducting quantum interference device is related to an amplitude of the external magnetic flux signal in form of single pulse inputted the radio frequency superconducting quantum interference device.

## Patentansprüche

1. System zum Modulieren einer Übergangsfrequenz eines supraleitenden Quantenbits, umfassend:
mindestens eine Vorspannungsleitung für eine supraleitende Hochfrequenz-Quanteninterferenzvorrichtung, die dazu ausgebildet ist, ein elektrisches Signal zum Justieren eines Zustands der supraleitenden Hochfrequenz-Quanteninterferenzvorrichtung zu übertragen;
mindestens eine supraleitende Hochfrequenz-Quanteninterferenzvorrichtung, die sich auf einem Chip befindet und in einem Bereich von 0,1 Mikrometer bis 20 Mikrometer von dem supraleitenden Quantenbit angeordnet ist, wobei ein Hystereseparameter der supraleitenden Hochfrequenz-Quanteninterferenzvorrichtung größer als 1 ist; und
mindestens ein supraleitendes Quantenbit, wobei die Übergangsfrequenz des supraleitenden Quantenbits durch Anlegen eines externen Magnetflusses (Φₑ) moduliert wird;
wobei das System zum Modulieren der Übergangsfrequenz des supraleitenden Quantenbits in einer Tiefsttemperaturumgebung in einer Größenordnung von 10 mK eines Verdünnungskühlschranks betreibbar ist,
wobei eine Beziehung zwischen einem Gesamtmagnetfluss (Φ) der supraleitenden Hochfrequenz-Quanteninterferenzvorrichtung und dem externen Magnetfluss (Φₑ) ein Verhalten einer Hysteresekurve aufweist, ein Signal des externen Magnetflusses in Form eines Impulses angelegt wird, um den Zustand der supraleitenden Hochfrequenz-Quanteninterferenzvorrichtung zu modulieren, und der Zustand der supraleitenden Hochfrequenz-Quanteninterferenzvorrichtung eine Richtung und eine Größe eines supraleitenden Ringstroms in der supraleitenden Hochfrequenz-Quanteninterferenzvorrichtung umfasst,
wobei die Richtung und die Größe des supraleitenden Ringstroms in der supraleitenden Hochfrequenz-Quanteninterferenzvorrichtung an einer Interzeptposition auf einer Gesamtmagnetflussachse einer Hystereseschleife des Gesamtmagnetflusses (Φ) und des externen Magnetflusses (Φₑ) der supraleitenden Hochfrequenz-Quanteninterferenzvorrichtung aufrechterhalten werden,
wobei die Übergangsfrequenz des supraleitenden Quantenbits durch den supraleitenden Ringstrom in der supraleitenden Hochfrequenz-Quanteninterferenzvorrichtung moduliert wird.

2. System nach Anspruch 1, wobei die Vorspannungsleitung für die supraleitende Hochfrequenz-Quanteninterferenzvorrichtung über eine gegenseitige Induktivität (M12) mit der supraleitenden Hochfrequenz-Quanteninterferenzvorrichtung gekoppelt ist;
wobei sich die Vorspannungsleitung für die supraleitende Hochfrequenz-Quanteninterferenzvorrichtung auf dem Chip befindet und über ein Koaxialkabel in dem Verdünnungskühlschrank mit einer Signalquelle in einer Raumtemperaturumgebung verbunden ist;
wobei die Vorspannungsleitung für die supraleitende Hochfrequenz-Quanteninterferenzvorrichtung dazu ausgebildet ist, das elektrische Signal über die gegenseitige Induktivität (M12) zwischen der Vorspannungsleitung und der supraleitenden Hochfrequenz-Quanteninterferenzvorrichtung in ein Magnetflusssignal umzuwandeln und das Magnetflusssignal in die supraleitende Hochfrequenz-Quanteninterferenzvorrichtung einzuspeisen;
wobei eine Bandbreite der Vorspannungsleitung der supraleitenden Hochfrequenz-Quanteninterferenzvorrichtung mindestens einen Frequenzbereich von einer Frequenz eines Gleichstromsignals bis 5 GHz abdeckt; und
wobei der Zustand der supraleitenden Hochfrequenz-Quanteninterferenzvorrichtung durch ein elektrisches Signal mit einer spezifischen Richtung und einer spezifischen Amplitude, das in die Vorspannungsleitung für die supraleitende Hochfrequenz-Quanteninterferenzvorrichtung eingespeist wird, moduliert wird.

3. System nach Anspruch 1 oder 2, wobei die supraleitende Hochfrequenz-Quanteninterferenzvorrichtung eine geschlossene Schleife ist, die einen supraleitenden Ring, der aus einem supraleitenden Material hergestellt ist, und mindestens einen Josephson-Übergang (J1), der Ende an Ende mit dem supraleitenden Ring verbunden ist, umfasst.

4. System nach einem der vorangehenden Ansprüche, wobei zwischen dem supraleitenden Quantenbit und der supraleitenden Hochfrequenz-Quanteninterferenzvorrichtung eine gegenseitige Induktivitätskopplung (M23) gebildet ist.

5. System nach Anspruch 2, wobei die Vorspannungsleitung für die supraleitende Hochfrequenz-Quanteninterferenzvorrichtung dazu ausgebildet ist, ein eingespeistes elektrisches Signal über die gegenseitige Induktivität (M12) in ein Magnetflusssignal umzuwandeln und das Magnetflusssignal in die supraleitende Hochfrequenz-Quanteninterferenzvorrichtung einzuspeisen, und das eingespeiste elektrische Signal ein Stromsignal oder ein Spannungssignal ist.

6. System nach Anspruch 4, wobei der supraleitende Ringstrom in der supraleitenden Hochfrequenz-Quanteninterferenzvorrichtung über die gegenseitige Induktivität (M23) in ein Magnetflusssignal umgewandelt und in das supraleitende Quantenbit eingespeist wird, um die Übergangsfrequenz des supraleitenden Quantenbits zu modulieren.

7. Verfahren zum Modulieren einer Übergangsfrequenz eines supraleitenden Quantenbits, das auf das System nach einem der Ansprüche 1 bis 6 angewendet wird, wobei das Verfahren umfasst:
Einspeisen (S210) des elektrischen Signals in Form eines einzelnen Impulses von einer Signalquelle in die Vorspannungsleitung für die supraleitende Hochfrequenz-Quanteninterferenzvorrichtung, wobei das elektrische Signal in Form eines einzelnen Impulses ein Stromsignal oder ein Spannungssignal ist;
Umwandeln (S220) des elektrischen Signals in Form eines einzelnen Impulses über eine gegenseitige Induktivität (M12) zwischen der Vorspannungsleitung für die supraleitende Hochfrequenz-Quanteninterferenzvorrichtung und der supraleitenden Hochfrequenz-Quanteninterferenzvorrichtung in ein Magnetflusssignal in Form eines Impulses;
Einspeisen (S230) des Magnetflusssignals in Form eines Impulses in die supraleitende Hochfrequenz-Quanteninterferenzvorrichtung, um einen Zustand der supraleitenden Hochfrequenz-Quanteninterferenzvorrichtung zu ändern, so dass die supraleitende Hochfrequenz-Quanteninterferenzvorrichtung in einem geänderten Zustand die Übergangsfrequenz des supraleitenden Quantenbits über eine gegenseitige Induktivität (M23) zwischen der supraleitenden Hochfrequenz-Quanteninterferenzvorrichtung und dem supraleitenden Quantenbit moduliert, wobei ein Hystereseparameter der supraleitenden Hochfrequenz-Quanteninterferenzvorrichtung größer als 1 ist.

8. Verfahren nach Anspruch 7, wobei das Einspeisen (S230) des Magnetflusssignals in Form eines Impulses in die supraleitende Hochfrequenz-Quanteninterferenzvorrichtung, um einen Zustand der supraleitenden Hochfrequenz-Quanteninterferenzvorrichtung zu ändern, so dass die supraleitende Hochfrequenz-Quanteninterferenzvorrichtung in einem geänderten Zustand die Übergangsfrequenz des supraleitenden Quantenbits über eine gegenseitige Induktivität (M23) zwischen der supraleitenden Hochfrequenz-Quanteninterferenzvorrichtung und dem supraleitenden Quantenbit moduliert, umfasst:
Umwandeln, unter Verwendung der Vorspannungsleitung, des elektrischen Signals in Form eines einzelnen Impulses mit einer spezifischen Richtung und einer spezifischen Amplitude in ein externes Magnetflusssignal in Form eines einzelnen Impulses über eine gegenseitige Induktivität (M12) zwischen der Vorspannungsleitung und der supraleitenden Hochfrequenz-Quanteninterferenzvorrichtung gemäß einer Hystereseschleifenbeziehung zwischen dem externen Magnetfluss (Φₑ) und dem Gesamtmagnetfluss (Φ) der supraleitenden Hochfrequenz-Quanteninterferenzvorrichtung, und Einspeisen des externen Magnetflusssignals in Form eines einzelnen Impulses in die supraleitende Hochfrequenz-Quanteninterferenzvorrichtung, um den Zustand der supraleitenden Hochfrequenz-Quanteninterferenzvorrichtung zu ändern, wobei der Zustand der supraleitenden Hochfrequenz-Quanteninterferenzvorrichtung eine Richtung und eine Größe eines supraleitenden Ringstroms in der supraleitenden Hochfrequenz-Quanteninterferenzvorrichtung umfasst; und
Modulieren, unter Verwendung des supraleitenden Ringstroms, der Übergangsfrequenz des supraleitenden Quantenbits über eine gegenseitige Induktivität (M23) zwischen der supraleitenden Hochfrequenz-Quanteninterferenzvorrichtung und dem supraleitenden Quantenbit;
wobei die Richtung des supraleitenden Ringstroms in der supraleitenden Hochfrequenz-Quanteninterferenzvorrichtung zu einer Richtung des Signals des externen Magnetflusses in Form eines einzelnen Impulses in Beziehung steht, das in die supraleitende Hochfrequenz-Quanteninterferenzvorrichtung eingespeist wird; und
wobei die Größe des supraleitenden Ringstroms in der supraleitenden Hochfrequenz-Quanteninterferenzvorrichtung zu einer Amplitude des Signals des externen Magnetflusses in Form eines einzelnen Impulses in Beziehung steht, das in die supraleitende Hochfrequenz-Quanteninterferenzvorrichtung eingespeist wird.

## Revendications

1. Système de modulation d'une fréquence de transition d'un bit quantique supraconducteur, comprenant :
au moins une ligne de polarisation pour un interféromètre quantique supraconducteur radiofréquence, configurée pour transmettre un signal électrique destiné à ajuster un état de l'interféromètre quantique supraconducteur radiofréquence ;
au moins un interféromètre quantique supraconducteur radiofréquence situé sur une puce et placé dans une plage de 0,1 micron à 20 microns du bit quantique supraconducteur, dans lequel un paramètre d'hystérésis de l'interféromètre quantique supraconducteur radiofréquence est supérieur à 1 ; et
au moins un bit quantique supraconducteur, dans lequel la fréquence de transition du bit quantique supraconducteur est modulée en appliquant d'un flux magnétique externe (ϕₑ) ;
dans lequel le système de modulation de la fréquence de transition du bit quantique supraconducteur peut fonctionner dans un environnement à température extrêmement basse de l'ordre de 10 mK d'un réfrigérateur à dilution,
dans lequel une relation entre un flux magnétique total (ϕ) de l'interféromètre quantique supraconducteur radiofréquence et le flux magnétique externe (ϕₑ) présente un comportement de courbe d'hystérésis, un signal de flux magnétique externe sous forme d'impulsion est appliqué pour moduler l'état de l'interféromètre quantique supraconducteur radiofréquence, et l'état de l'interféromètre quantique supraconducteur radiofréquence comprend une direction et une grandeur d'un courant d'anneau supraconducteur dans l'interféromètre quantique supraconducteur radiofréquence,
dans lequel la direction et la grandeur du courant d'anneau supraconducteur dans l'interféromètre quantique supraconducteur radiofréquence sont maintenues dans une position d'interception sur un axe de flux magnétique total d'une boucle d'hystérésis du flux magnétique total (ϕ) et du flux magnétique externe (ϕₑ) de l'interféromètre quantique supraconducteur radiofréquence,
dans lequel la fréquence de transition du bit quantique supraconducteur est modulée par le courant d'anneau supraconducteur dans l'interféromètre quantique supraconducteur radiofréquence.

2. Système selon la revendication 1, dans lequel la ligne de polarisation pour l'interféromètre quantique supraconducteur radiofréquence est couplée à l'interféromètre quantique supraconducteur radiofréquence par l'intermédiaire d'une inductance mutuelle (M12) ;
dans lequel la ligne de polarisation pour l'interféromètre quantique supraconducteur radiofréquence est située sur la puce et est connectée à une source de signal dans un environnement à température ambiante par l'intermédiaire d'un câble coaxial dans le réfrigérateur à dilution ;
dans lequel la ligne de polarisation pour l'interféromètre quantique supraconducteur radiofréquence est configurée pour convertir le signal électrique en un signal de flux magnétique par l'intermédiaire de l'inductance mutuelle (M12) entre la ligne de polarisation et l'interféromètre quantique supraconducteur radiofréquence et injecter le signal de flux magnétique dans l'interféromètre quantique supraconducteur radiofréquence ;
dans lequel une largeur de bande de la ligne de polarisation de l'interféromètre quantique supraconducteur radiofréquence couvre au moins une plage de fréquences allant d'une fréquence d'un signal DC jusqu'à 5 GHz ; et
dans lequel l'état de l'interféromètre quantique supraconducteur radiofréquence est modulé par un signal électrique avec une direction spécifique et une amplitude spécifique injecté dans la ligne de polarisation pour l'interféromètre quantique supraconducteur radiofréquence.

3. Système selon la revendication 1 ou 2, dans lequel l'interféromètre quantique supraconducteur radiofréquence est une boucle fermée comprenant un anneau supraconducteur constitué d'un matériau supraconducteur et au moins une jonction Josephson (J1) connectée à l'anneau supraconducteur de bout en bout.

4. Système selon l'une quelconque des revendications précédentes, dans lequel un couplage d'inductance mutuelle (M23) est formé entre le bit quantique supraconducteur et l'interféromètre quantique supraconducteur radiofréquence.

5. Système selon la revendication 2, dans lequel la ligne de polarisation pour l'interféromètre quantique supraconducteur radiofréquence est configurée pour convertir un signal électrique d'entrée en un signal de flux magnétique par l'intermédiaire de l'inductance mutuelle (M12) et injecter le signal de flux magnétique dans l'interféromètre quantique supraconducteur radiofréquence, et le signal électrique d'entrée est un signal de courant ou un signal de tension.

6. Système selon la revendication 4, dans lequel le courant d'anneau supraconducteur dans l'interféromètre quantique supraconducteur radiofréquence est converti en un signal de flux magnétique par l'intermédiaire de l'inductance mutuelle (M23) et injecté dans le bit quantique supraconducteur pour moduler la fréquence de transition du bit quantique supraconducteur.

7. Procédé de modulation d'une fréquence de transition d'un bit quantique supraconducteur, appliqué au système selon l'une quelconque des revendications 1 à 6, dans lequel le procédé comprend de :
injecter (S210) le signal électrique sous forme d'impulsion individuelle à partir d'une source de signal dans la ligne de polarisation pour l'interféromètre quantique supraconducteur radiofréquence, dans lequel le signal électrique sous forme d'impulsion individuelle est un signal de courant ou un signal de tension ;
convertir (S220) le signal électrique sous forme d'impulsion individuelle en un signal de flux magnétique sous forme d'impulsion par l'intermédiaire d'une inductance mutuelle (M12) entre la ligne de polarisation pour l'interféromètre quantique supraconducteur radiofréquence et l'interféromètre quantique supraconducteur radiofréquence ;
injecter (S230) le signal de flux magnétique sous forme d'impulsion dans l'interféromètre quantique supraconducteur radiofréquence afin de changer un état de l'interféromètre quantique supraconducteur radiofréquence, de sorte que l'interféromètre quantique supraconducteur radiofréquence dans un état changé module la fréquence de transition du bit quantique supraconducteur par l'intermédiaire d'une inductance mutuelle (M23) entre l'interféromètre quantique supraconducteur radiofréquence et le bit quantique supraconducteur, dans lequel un paramètre d'hystérésis de l'interféromètre quantique supraconducteur radiofréquence est supérieur à 1.

8. Procédé selon la revendication 7, dans lequel l'injection (S230) du signal de flux magnétique sous forme d'impulsion dans l'interféromètre quantique supraconducteur radiofréquence afin de changer un état de l'interféromètre quantique supraconducteur radiofréquence, de sorte que l'interféromètre quantique supraconducteur radiofréquence dans un état changé module la fréquence de transition du bit quantique supraconducteur par l'intermédiaire d'une inductance mutuelle (M23) entre l'interféromètre quantique supraconducteur radiofréquence et le bit quantique supraconducteur, comprend de :
convertir, en utilisant la ligne de polarisation, le signal électrique sous forme d'impulsion individuelle avec une direction spécifique et une amplitude spécifique en un signal de flux magnétique externe sous forme d'impulsion individuelle par l'intermédiaire d'une inductance mutuelle (M12) entre la ligne de polarisation et l'interféromètre quantique supraconducteur radiofréquence en fonction d'une relation de boucle d'hystérésis entre le flux magnétique externe (ϕₑ) et le flux magnétique total (ϕ) de l'interféromètre quantique supraconducteur radiofréquence, et injecter le signal de flux magnétique externe sous forme d'impulsion individuelle dans l'interféromètre quantique supraconducteur radiofréquence afin de changer l'état de l'interféromètre quantique supraconducteur radiofréquence, dans lequel l'état de l'interféromètre quantique supraconducteur radiofréquence comprend une direction et une grandeur d'un courant d'anneau supraconducteur dans l'interféromètre quantique supraconducteur radiofréquence ; et
moduler, en utilisant le courant d'anneau supraconducteur, la fréquence de transition du bit quantique supraconducteur par l'intermédiaire d'une inductance mutuelle (M23) entre l'interféromètre quantique supraconducteur radiofréquence et le bit quantique supraconducteur ;
dans lequel la direction du courant d'anneau supraconducteur dans l'interféromètre quantique supraconducteur radiofréquence est liée à une direction du signal de flux magnétique externe sous forme d'impulsion individuelle injectée dans l'interféromètre quantique supraconducteur radiofréquence ; et
dans lequel la grandeur du courant d'anneau supraconducteur dans l'interféromètre quantique supraconducteur radiofréquence est liée à une amplitude du signal de flux magnétique externe sous forme d'impulsion individuelle injectée dans l'interféromètre quantique supraconducteur radiofréquence.
